# EUROPÄISCHE PATENTANMELDUNG

(11) **EP 1 505 861 A2**
(43) Veröffentlichungstag der Anmeldung: **09.02.2005**
(21) Anmeldenummer: 04017251.2
(22) Anmeldetag: 21.07.2004
(51) Int. Cl.: H05K 5/02

(54) **Gehäuse**

(30) Priorität: 21.07.2003 DE 10333107
(71) Anmelder: Schmidt, Peter, 51149 Köln (Porz) (DE)
(72) Erfinder: Schmidt, Peter, 51149 Köln (Porz) (DE)
(74) Vertreter: Feldkamp, Rainer, Dipl.-Ing.

(57) **Zusammenfassung**

Ein Ghäuse ist entlang einer Trennebene (E) in zumindest zwei miteinander verbindbare Hälften (1, 5) unterteilt ist, die über Befestigungsmittel (9) miteinander lösbar verbunden sind. Die aufeinander gerichteten Umfangskanten der Hälften (1, 5) weisen komplementäre, sich im Wesentlichen senkrecht zur Trennebene (E) erstreckende Verzahnungen (2, 3 / 6, 7) auf, die aus Zähnen (3 / 7) und Zahnlücken (2 / 6) bestehen, in die die Zähne ( 3 / 7) eingreifen. Die Zähne (3 / 7) springen über die Trennebene (E) hinaus vor und weisen an ihren freien Enden sich nach außen erstreckende Vorsprünge (4 / 8) derart auf, dass bei Eingriff der Verzahnungen (2, 3 / 6, 7) ineinander die Vorsprünge (4 / 8) zwischen sich einen Abstand aufweisen, in den ein elastischer Ring (9) einlegbar ist, der das Gehäuse umgibt und eine Trennung der Hälften (1, 5) voneinander verhindert.

## Beschreibung

Die Erfindung bezieht sich auf ein Gehäuse der im Oberbegriff des Anspruchs 1 genannten Art.

Derartige Gehäuse, wie sie in vielen Fällen zur Aufnahme von Bauteilen, beispielsweise elektronischen Bauteilen und Geräten verwendet werden, weisen in vielen Fällen die Möglichkeit auf, dass sie geöffnet werden können, um einen Zugriff an das Innere des Gehäuses zu erhalten. Entsprechend ist das Gehäuse in Hälften unterteilt, wobei die Größe der Hälften nicht gleich sein muss. Die einzelnen Hälften werden dann über Befestigungsmittel, wie z. B. Schrauben, miteinander verbunden, die wieder gelöst werden können. Das Öffnen und erneute Schließen des Gehäuses durch Verbinden der Gehäusehälften ist in vielen Fällen aufwändig und erfordert den Einsatz von Werkzeugen, wie z. B. Schraubenziehern, um Verbindungsschrauben zu befestigen.

Weiterhin ist es möglich, die Hälften eines Gehäuses ineinander zu stecken oder durch eine Schraubverbindung miteinander zu verbinden, wobei die eine Gehäusehälfte ein Innengewinde und die andere Hälfte ein Aussengewinde aufweist, doch ist auch hierbei die Handhabung zeitaufwändig und es müssen Sicherungen vorgesehen sein, die ein ungewolltes Lösen der Verschraubung verhindern.

Der Erfindung liegt die Aufgabe zugrunde, ein Gehäuse der Eingangs genannten Art zu schaffen, das bei einfachem Aufbau eine Trennung der Hälften voneinander ohne Einsatz von Werkzeugen und ohne die Gefahr einer ungewollten Trennung ermöglicht.

Diese Aufgabe wird durch die im Patentanspruch 1 angegebenen Merkmale gelöst.

Vorteilhafte Ausgestaltungen und Weiterbildungen der Erfindung ergeben sich aus den Unteransprüchen.

Durch die erfindungsgemäße Ausgestaltung des Gehäuses ist es möglich, die Gehäusehälften sehr schnell dadurch miteinander zu verbinden, dass die stirnseitigen Verzahnungen der beiden Gehäusehälften ineinander gesteckt werden, worauf am Aussenumfang des Gehäuses ein elastischer Ring zwischen die Vorsprünge an den Enden der jeweiligen Verzahnungen eingelegt wird, der sicher eine ungewollte Trennung verhindert. Durch einfaches Abstreifen des elastischen Ringes können die Hälften wieder voneinander getrennt werden.

Wenn der Aussenumfang des elastischen Ringes über die Vorsprünge hinaus nach außen vorspringt, kann dieser Ring gleichzeitig ein elastisches Auflageelement für das Gehäuse bilden, wenn dieses auf einer Auflagefläche abgelegt wird.

Um die Anordnung der beiden Hälften des Gehäuses aneinander vor dem Aufbringen des elastischen Ringes zu erleichtern, können weiterhin ineinander greifende Führungseinrichtungen vorgesehen sein, die die Lage der Hälften zueinander in Richtung der Trennebene festlegen.

Ausführungsbeispiele der Erfindung werden im Folgenden anhand der Zeichnung noch näher erläutert.

In der Zeichnung zeigen:
Figur 1 eine Draufsicht auf eine Ausführungsform einer Hälfte des Gehäuses bei Betrachtung einer Richtung senkrecht zur Trennebene;
Figur 2 eine Seitenansicht der Gehäusehälfte nach Figur 1;
Figur 3 eine Schnittansicht einer zu der Gehäusehälfte nach den Figuren 1 und 2 komplementären Gehäusehälfte;
Figur 4 eine Schnittansicht von zwei miteinander verbundenen Gehäusehälften;
Figur 5 eine vergrößerte Ansicht der in Figur 4 mit V bezeichneten Einzelheit;
Figur 6 eine perspektivische Ansicht einer weiteren Ausführungsform des Gehäuses;
Figur 7 eine Schnittansicht des Gehäuses nach Figur 6 entlang einer längsgerichteten diametralen Ebene;
Figur 8 eine vergrößerte Ansicht der Einzelheit VIII nach Figur 7;
Figur 9 ein Anwendungsbeispiel des Gehäuses nach den Figuren 1-5.

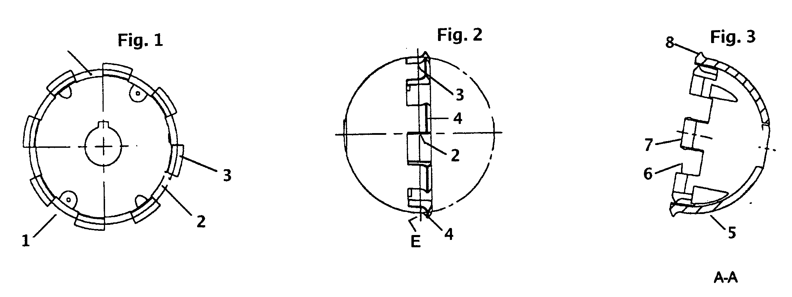

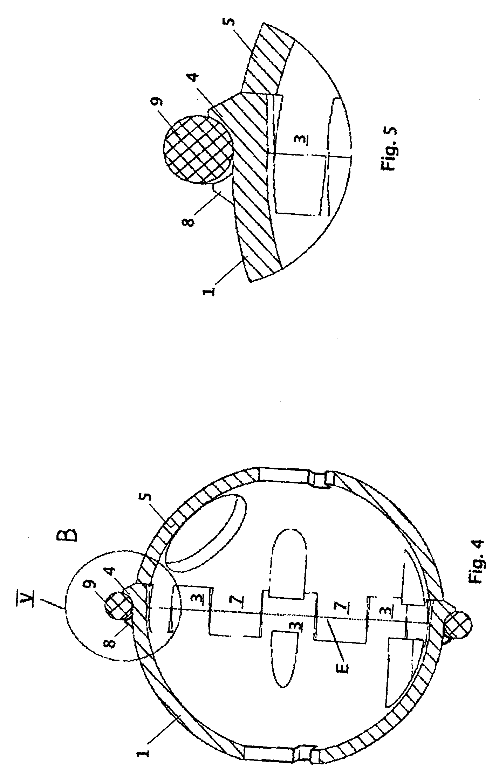

In Figur 1 ist eine Ausführungsform einer Hälfte 1 eines in diesem Fall im Wesentlichen kugelförmigen Gehäuses dargestellt, das entlang einer in Figur 2 gezeigten Trennebene E in zwei Hälften 1, 5 unterteilt ist. Die Gehäusehälften 1, 5 weisen in der insbesondere aus den Figuren 2 und 3 ersichtlichen Weise an ihren aufeinander gerichteten Umfangskanten komplementäre, sich im Wesentlichen senkrecht zur Trennebene E erstreckende Verzahnungen auf, die für die Hälfte 1 aus Zähnen 3 und Zahnlücken 2 bestehen, während bei der zweiten Hälfte 5 Zähne 7, die in die Zahnlücken 2 der ersten Hälfte 1 eingreifen, sowie Zahnlücken 6 vorgesehen sind, in die die Zähne 3 der ersten Hälfte 1 eingreifen, wie dies aus Figur 4 zu erkennen ist. Die Zähne 3, 7 weisen jeweils an ihren freien Enden Vorsprünge 4, 8 auf, die sich nach aussen über den Aussenumfang des Gehäuses hinaus erstrecken und in einer zur Trennebene senkrechten Richtung über diese hinaus derart vorspringen, dass bei Eingriff der Verzahnungen ineinander die Vorsprünge 4, 8 zwischen sich einen Abstand aufweisen, in dem ein elastischer Ring 9 einlegbar ist, wie dies insbesondere aus Figur 5 zu erkennen ist.

Wenn die komplementären Verzahnungen der beiden Hälften ineinander gesteckt sind, kann der Ring über eine Hälfte so weit aufgeschoben werden, dass er in den Abstand zwischen den beiden Vorsprüngen 4, 8 gelangt und eine Trennung der beiden Gehäusehälften voneinander verhindert.

Dadurch, dass dieser Ring 9 mit seinem Aussenumfang über die Vorsprünge 4, 8 nach außen hin vorspringt, kann dieser als elastischer Auflagering für das Gehäuse dienen.

Um ein Führen der beiden Gehäusehälften ineinander zum Verbinden zu erleichtern, können nicht gezeigte Führungseinrichtungen vorgesehen sein, die die Lage der beiden Hälften in Richtung der Trennebene festlegen.

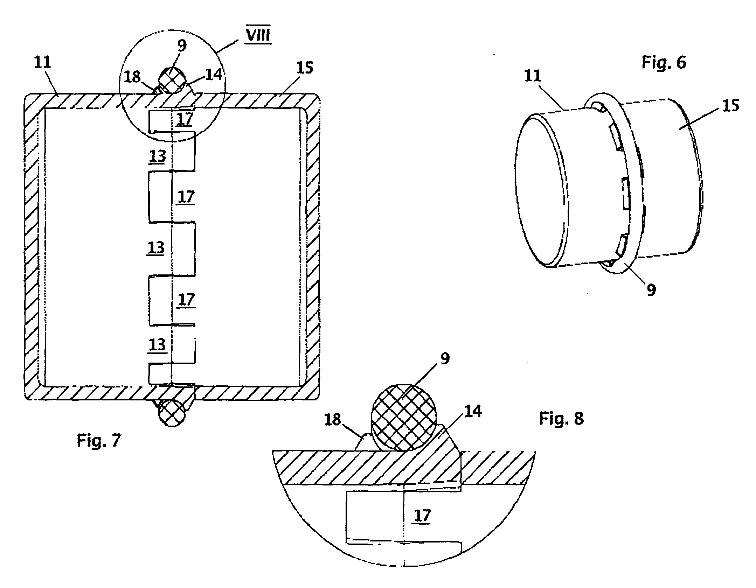

In den Figuren 1 und 5 ist eine Ausführungsform des Gehäuses mit Kugelform dargestellt. Selbstverständlich kann dieses Gehäuse beliebige Formen aufweisen, wie dies beispielsweise aus den Figuren 6-8 zu erkennen ist. In diesem Fall ist das Gehäuse im wesentlichen zylindrisch ausgebildet und besteht aus zwei Hälften 11, 15, die in der gleichen Weise wie bei der Ausführungsform nach den Figuren 1-5 ineinander greifende Verzahnungen aus Zähnen 13, 17 an ihren aufeinander gerichteten Umfangskanten aufweisen. Auch hier weisen die Zähne an ihren freien Enden wiederum Vorsprünge 14, 18 auf, die im ineinander gesteckten Zustand der beiden Gehäusehälften einen Abstand aneinander aufweisen, in den ein elastischer Ring 9 einzulegen ist, um die beiden Hälften aneinander zu befestigen.

Selbstverständlich könnte das Gehäuse auch andere Querschnittsformen, beispielsweise quadratische oder vieleckige Querschnittsformen aufweisen, da sich der elastische Ring 9 sehr leicht an beliebige Querschnittsformen anpassen lässt.

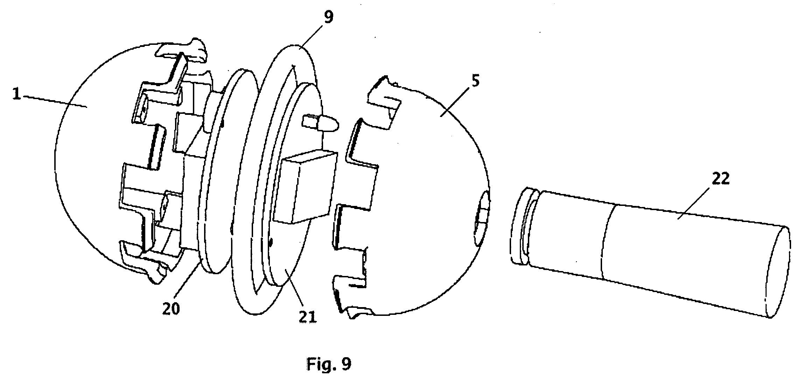

Figur 9 zeigt ein Anwendungsbeispiel eines Gehäuses nach den Figuren 1-5. Bei dieser Ausführungsform sind in beiden Gehäusehälften jeweilige Leiterplatten 20, 21 einer elektronischen Schaltung angeordnet, und die zweite Gehäusehälfte 5 dient zur Befestigung eines Ansatzes 22, der beispielsweise eine Steckverbindung zu einem anderen elektrischen Gerät herstellen kann.

## Patentansprüche

1. Gehäuse, das entlang einer Trennebene (E) in zumindest zwei miteinander verbindbare Hälften (1, 5) unterteilt ist, die über Befestigungsmittel (9) miteinander lösbar verbunden sind,
**dadurch gekennzeichnet, dass** die aufeinander gerichteten Umfangskanten der Hälften (1, 5) komplementäre, sich im Wesentlichen senkrecht zur Trennebene (E) erstreckende Verzahnungen (2, 3 / 6, 7) aufweisen, die aus Zähnen (3 / 7) und Zahnlücken (2 / 6) bestehen, in die die Zähne ( 3 / 7) eingreifen, daß die Zähne (3 / 7) über die Trennebene (E) hinaus vorspringen und an ihren freien Enden sich nach außen erstreckende Vorsprünge (4 / 8) derart aufweisen, dass bei Eingriff der Verzahnungen (2, 3 / 6, 7) ineinander die Vorsprünge (4 / 8) zwischen sich einen Abstand aufweisen, in den ein elastischer Ring (9) einlegbar ist, der das Gehäuse umgibt und eine Trennung der Hälften (1, 5) voneinander verhindert.

2. Gehäuse nach Anspruch 1, **dadurch gekennzeichnet, dass** das Gehäuse im Wesentlichen kugelfömig ist und dass die Trennebene (E) in einer diametralen Ebene liegt.

3. Gehäuse nach Anspruch 1, **dadurch gekennzeichnet, dass** das Gehäuse im langgestreckt ist und dass sich die Trennebene (E) quer zur Längsachse des Gehäuses erstreckt.

4. Gehäuse nach einem der Ansprüche 1 bis 3, **dadurch gekennzeichnet, dass** die Hälften (1, 5) ineinander greifende Führungseinrichtungen aufweist, die die Lage den Hälften (1, 5) zueinander in Richtung der Trennebene (E) festlegen.

5. Gehäuse nach einem der Ansprüche 1 bis 4, **dadurch gekennzeichnet, dass** sich der elastische Ring (9) mit seinem Außenumfang über die Vorsprünge (4, 8) hinaus nach außen vorspringt.
